# EUROPEAN PATENT APPLICATION

(11) **EP 4 815 312 A1**
(43) Date of publication of application: **30.09.2026**
(21) Application number: 25210417.9
(22) Date of filing: 22.10.2025
(51) Int. Cl.: H03L 7/093

(54) **PHASE LOCKED LOOP AND OPERATION METHOD THEREOF**

(30) Priority: 28.03.2025 KR 20250040590
(71) Applicant: Samsung Electronics Co., Ltd., Suwon-si, Gyeonggi-do 16677 (KR)
(72) Inventor: KIM, Hyungjun, Suwon-si (KR); PARK, Jaewoo, Suwon-si (KR); KWAK, Myoungbo, Suwon-si (KR); BAEK, Seungyeob, Suwon-si (KR); JUNG, Jinook, Suwon-si (KR)
(74) Representative: Marks & Clerk LLP

(57) **Abstract**

A phase locked loop is provided. The phase locked loop includes: a digitally controlled oscillator configured to generate an output clock according to a frequency control signal; a frequency divider circuit configured to generate a feedback clock by frequency dividing the output clock based on a first divide ratio value; a phase detection circuit configured to generate a phase difference signal according to a phase difference between the feedback clock and an externally provided reference clock; a loop filter circuit configured to generate a frequency control raw signal based on the phase difference signal; and a peaking suppression circuit configured to generate the frequency control signal by limiting a fluctuation range of the frequency control raw signal.

## Description

### BACKGROUND

The present disclosure relates to a phase locked loop and an operation method thereof.

An electronic device may operate based on a clock signal. Accordingly, precision of the clock signal is required for accurate operation of the electronic device. A phase locked loop may be used to generate clock signals of precise frequency.

The phase locked loop may generate a clock signal with a specific frequency based on a reference clock. However, errors may occur in the operation of the phase locked loop due to electrostatic discharge (ESD), surge, etc. In this case, a clock signal having an unintended frequency may be generated, which may cause errors in the operation of the electronic device while operating based on the clock signal.

### SUMMARY

One or more embodiments provide a phase locked loop with minimized operating error and an operation method thereof.

According to an aspect of an embodiment, a phase locked loop includes: a digitally controlled oscillator configured to generate an output clock according to a frequency control signal; a frequency divider circuit configured to generate a feedback clock by frequency dividing the output clock based on a first divide ratio value; a phase detection circuit configured to generate a phase difference signal according to a phase difference between the feedback clock and an externally provided reference clock; a loop filter circuit configured to generate a frequency control raw signal based on the phase difference signal; and a peaking suppression circuit configured to generate the frequency control signal by limiting a fluctuation range of the frequency control raw signal.

According to another aspect of an embodiment, an operation method of a phase locked loop including a digitally controlled oscillator generating an output clock according to a frequency control signal, includes: receiving a divide ratio control signal indicating a first divide ratio value; determining a first code value suppression range corresponding to the first divide ratio value; and clamping the frequency control signal within the first code value suppression range while the frequency control signal indicates the first divide ratio value.

According to another aspect of an embodiment, a phase locked loop includes: an oscillator configured to generate an output clock according to a frequency control signal; a frequency divider circuit configured to divide the output clock based on a divide ratio value indicated by a divide ratio control signal; and a peaking suppression circuit configured to limit a fluctuation range of the frequency control signal according to the divide ratio value.

At least some of the above and other features of the invention are set out in the claims.

### BRIEF DESCRIPTION OF DRAWINGS

The above and other aspects will be more apparent from the following description of embodiments taken in conjunction with the accompanying drawings.
FIG. 1 is a block diagram showing a phase locked loop according to an embodiment.
FIG. 2 is a timing diagram example showing changes in signals when a glitch occurs in a reference clock according to an embodiment.
FIG. 3 is a block diagram showing configuration of a peaking suppression circuit according to an embodiment.
FIG. 4 is a timing diagram showing operation of a phase locked loop according to an embodiment.
FIG. 5 is a drawing showing operation of a threshold value generation circuit according to an embodiment.
FIG. 6 is a diagram showing how a code limiter circuit performs a peaking suppression operation according to an embodiment.
FIG. 7 is a diagram showing the effect of peaking suppression according to an embodiment.
FIG. 8 is a flowchart showing operation of a phase locked loop according to an embodiment.
FIG. 9 is a flowchart showing operation S120 of FIG. 8 according to an embodiment.
FIG. 10 is a diagram showing a frequency control raw signal corresponding to a divide ratio control signal indicating different divide ratio values according to an embodiment.
FIG. 11 is a block diagram showing how a peaking suppression circuit predetermines a code value suppression range for each of a plurality of divide ratio values according to an embodiment.
FIG. 12 is a flowchart showing operation of a phase locked loop according to an embodiment.
FIG. 13 is a block diagram showing in more detail how a peaking suppression circuit interpolates predetermined code value suppression ranges according to an embodiment.
FIG. 14 is a flowchart showing operation of a phase locked loop according to an embodiment.
FIG. 15 is a block diagram showing a phase locked loop according to an embodiment.
FIG. 16 is a block diagram showing a communication system according to an embodiment.

### DETAILED DESCRIPTION

Hereinafter, embodiments will be described in detail and clearly to such an extent that an ordinary one in the art easily implements the present disclosure. Specific details such as detailed components and structures are merely provided to assist the overall understanding of the various embodiments. Therefore, it should be apparent to those skilled in the art that various changes and modifications of embodiments described herein may be made without departing from the scope of the present disclosure. Moreover, descriptions of well-known functions and structures are omitted for clarity and brevity. In the drawings or in the detailed description, configurations may be connected with any other components except for components illustrated in a drawing or described in the detailed description. The terms described below are terms defined in consideration of the functions of the present disclosure and are not limited to a specific function. The definitions of the terms should be determined based on the contents throughout the specification.

Components that are described in the detailed description with reference to the terms "driver", "block", etc. will be implemented with hardware, or a combination of software and hardware. For example, the software may be a machine code, firmware, an embedded code, and application software. For example, the hardware may include an electrical circuit, an electronic circuit, a processor, a computer, integrated circuit cores, a pressure sensor, a microelectromechanical system (MEMS), a passive element, or a combination thereof.

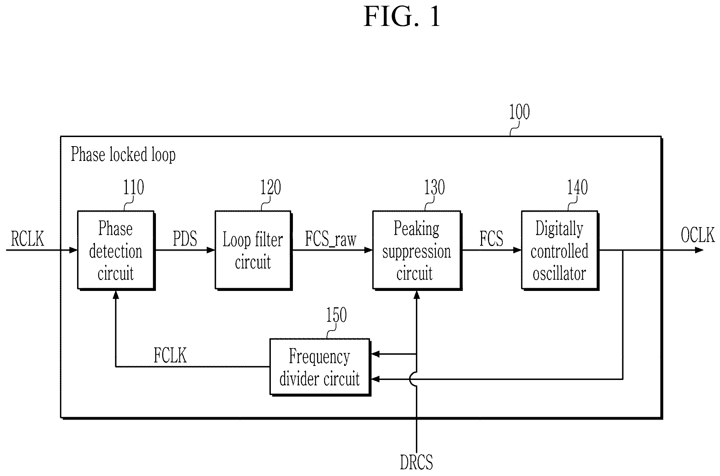

FIG. 1 is a block diagram showing a phase locked loop according to an embodiment. Referring to FIG. 1, a phase locked loop 100 may receive a reference clock RCLK and a divide ratio control signal DRCS. The phase locked loop 100 may generate an output clock OCLK according to the reference clock RCLK and a divide ratio control signal DRCS. The phase locked loop 100 may include a phase detection circuit 110, a loop filter circuit 120, a peaking suppression circuit 130, a digitally controlled oscillator (i.e., a digitally controlled oscillation circuit) 140, and a frequency divider circuit 150.

For the sake of simplicity, in the following description, it is assumed that the phase locked loop 100 is a digital phase locked loop. For example, below, it is assumed that signals generated by the components within the phase locked loop 100 are digital signals. However, embodiments are not limited thereto. For example, the phase locked loop 100 may be implemented as an analog phase locked loop.

The phase detection circuit 110 may receive a feedback clock FCLK and the reference clock RCLK. The phase detection circuit 110 may generate a phase difference signal PDS based on a phase difference between the feedback clock FCLK and the reference clock RCLK.

In an embodiment, the reference clock RCLK may be provided from an oscillator external to the phase locked loop PLL. For example, the reference clock RCLK may be provided from a crystal oscillator external to the phase locked loop PLL. However, embodiments are not limited to a specific type of oscillator that generates the reference clock RCLK.

In an embodiment, a frequency of the reference clock RCLK may be lower than a frequency of the output clock OCLK.

The loop filter circuit 120 may receive the phase difference signal PDS. The loop filter circuit 120 may generate a frequency control raw signal FCS_raw for controlling the frequency of the output clock OCLK based on the phase difference signal PDS. For example, the loop filter circuit 120 may attenuate noise component of the phase difference signal PDS, and may generate the frequency control raw signal FCS_raw that causes the digitally controlled oscillator 140 to generate the output clock OCLK having a frequency corresponding to the phase difference signal PDS.

The peaking suppression circuit 130 may receive the frequency control raw signal FCS_raw and the divide ratio control signal DRCS. The peaking suppression circuit 130 may generate a frequency control signal FCS based on the frequency control raw signal FCS_raw and the divide ratio control signal DRCS. For example, the peaking suppression circuit 130 may generate a frequency control signal FCS by clamping the frequency control raw signal FCS_raw based on the divide ratio control signal DRCS. That is, the peaking suppression circuit 130 may perform a peaking suppression operation for the frequency control signal FCS. More specifically, the peaking suppression circuit 130 may generate the frequency control signal FCS by clamping the frequency control raw signal FCS_raw within a certain code range according to a divide ratio value indicated by the divide ratio control signal DRCS. In this case, the variation range of the frequency control signal FCS may be limited.

The digitally controlled oscillator 140 may generate the output clock OCLK according to the frequency control signal FCS. For example, the digitally controlled oscillator 140 may generate an output clock OCLK having a frequency corresponding to a code value of the frequency control signal FCS. In this case, because the fluctuation range of the frequency control signal FCS is limited by the peaking suppression circuit 130, excessive fluctuation of the frequency of the output clock OCLK may be limited (e.g., suppressed).

The frequency divider circuit 150 may receive the divide ratio control signal DRCS and the output clock OCLK. The frequency divider circuit 150 may generate the feedback clock FCLK by dividing (e.g., frequency dividing) the output clock OCLK based on a divide ratio value indicated by the divide ratio control signal DRCS. That is, the frequency divider circuit 150 may generate the feedback clock FCLK having a frequency corresponding to a value obtained by dividing the frequency of the output clock OCLK by a divide ratio value indicated by the divide ratio control signal DRCS. In this case, the frequency of the feedback clock FCLK may be smaller than the frequency of the output clock OCLK.

The feedback clock FCLK may be provided (i.e., fed back) to the phase detection circuit 110. In this case, the phase difference signal PDS generated by the phase detection circuit 110 may be changed by the feedback clock FCLK, and accordingly, the frequency control raw signal FCS_raw and the frequency control signal FCS may be changed. In this way, the frequency of the output clock OCLK may be adjusted until it has a frequency corresponding to the divide ratio value indicated by the divide ratio control signal DRCS.

Glitches may occur in the reference clock RCLK of the phase locked loop 100 due to various external influences such as electrostatic discharge (ESD), surge, etc. In this case, an error may occur in the phase difference signal PDS because the phase detection circuit 110 incorrectly recognizes the phase difference between the feedback clock FCLK and the reference clock RCLK, and accordingly, an excessive swing may occur in the code value of the frequency control raw signal FCS_raw.

When the phase locked loop 100 does not include the peaking suppression circuit 130 (or, when the phase locked loop 100 does not perform the peaking suppression operation), the digitally controlled oscillator 140 may operate based on the frequency control raw signal FCS_raw. In this case, the frequency of the output clock OCLK may change unintentionally excessively due to fluctuation of the frequency control raw signal FCS_raw. Accordingly, errors may occur in the operation of an electronic device which operates based on the output clock OCLK.

On the other hand, according to an embodiment, even if an excessive swing occurs in the code value of the frequency control raw signal FCS_raw, the peaking suppression circuit 130 may limit the fluctuation of the code value of the frequency control signal FCS. In this case, unlike the frequency control raw signal FCS_raw, the frequency control signal FCS may not significantly fluctuate, and thus, the phenomenon of the frequency of the output clock OCLK unintentionally changing excessively may be prevented. Therefore, according to an embodiment, the probability of an error occurring in the operation of the electronic device which operates based on the output clock OCLK may be minimized.

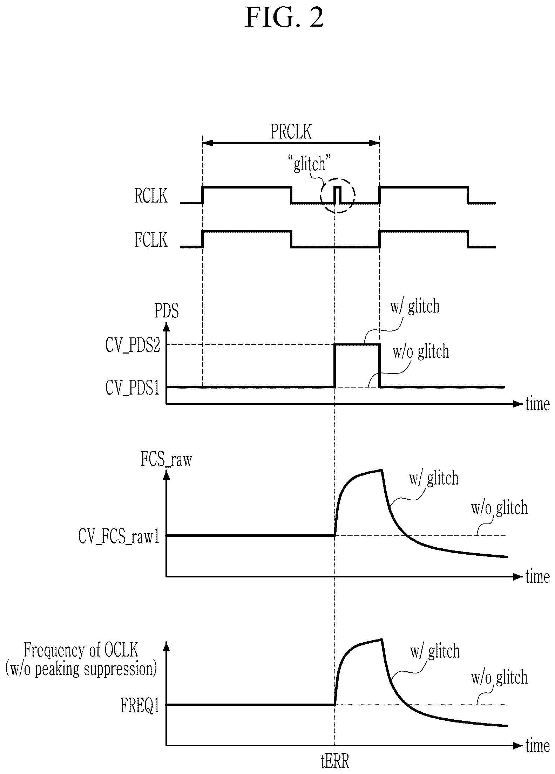

FIG. 2 is a timing diagram example showing changes in the signals of FIG. 1 when a glitch occurs in the reference clock. Hereinafter, with reference to FIGS. 1 and 2, it is assumed that a glitch occurs in the reference clock after a sufficient amount of time has elapsed after the divide ratio value indicated by the divide ratio control signal DRCS has changed (i.e., when the output clock OCLK is in a steady state).

The horizontal axis of FIG. 2 represents time. The vertical axis of the graph for the reference clock RCLK and the feedback clock FCLK illustrated in FIG. 2 represent a voltage level; the vertical axis of the graph for the phase difference signal PDS and the frequency control raw signal FCS_raw represent a code value; and the vertical axis of the graph for the output clock OCLK represent a frequency.

When the output clock OCLK is in a steady state, the frequencies of the reference clock RCLK and the feedback clock FCLK may be the same. For example, an interval between the rising edges of the reference clock RCLK and an interval between the rising edges of the feedback clock FCLK may both be the reference clock period PRCLK.

For a more concise explanation, FIG. 2 illustrates that the phases of the reference clock RCLK and the feedback clock FCLK are the same when the output clock OCLK is in a steady state, but embodiments are not limited thereto. For example, when the output clock OCLK is in the steady state, the phases of the reference clock RCLK and the feedback clock FCLK may be implemented differently depending on an implementation scheme of the phase detection circuit 110.

At an error time point tERR, a glitch may occur in the reference clock RCLK. For example, due to various causes such as surge, ESD, etc., the voltage level of the reference clock RCLK may transition to logic high at the error time point tERR or may rise higher than a voltage level corresponding to the logic high. At the error time point tERR, the feedback clock FCLK may remain at a voltage level corresponding to a logic low, and in this regard a glitch may not occur in the feedback clock FCLK at the error time point tERR.

When the output clock OCLK is in a steady state, the code value of the phase difference signal PDS may be maintained constant. For example, the code value of the phase difference signal PDS may be the first code value CV_PDS1 until the error time point tERR.

If a glitch occurs in the reference clock RCLK, the phase detection circuit 110 may incorrectly detect the phase difference between the reference clock RCLK and the feedback clock FCLK. For example, the phase detection circuit 110 may recognize a time point where a glitch occurs in the reference clock RCLK as a time point where the reference clock RCLK transitions to logic high, and accordingly, the phase detection circuit 110 may incorrectly recognize the phase difference between the reference clock RCLK and the feedback clock FCLK as an excessively large value. In this case, the code value of the phase difference signal PDS may be different from the code value in the steady state. For example, at the error time point tERR, the code value of the phase difference signal PDS may rise to a second code value CV_PDS2. That is, if a glitch does not occur in the reference clock RCLK, the code value of the phase difference signal PDS may be maintained constant; and if a glitch occurs in the reference clock RCLK, the code value of the phase difference signal PDS may temporarily change at the error time point tERR.

For a more concise explanation, a representative example in which a phase detection circuit 110 generates the phase difference signal PDS having a code value corresponding to the phase difference between the reference clock RCLK and a feedback clock FCLK has been illustrated in FIG. 2, but embodiments are not limited to a specific method in which the phase detection circuit 110 generates the phase difference signal PDS. That is, regardless of the specific way in which the phase detection circuit 110 generates the phase difference signal PDS, if a glitch occurs in the reference clock RCLK, an unintended change may occur in the code value of the phase difference signal PDS.

While the code value of the phase difference signal PDS is kept constant, the code value of the frequency control raw signal FCS_raw may be kept constant. For example, the code value of the frequency control raw signal FCS_raw may be the first code value CV_FCS_raw1 before the error time point tERR.

When the code value of the phase difference signal PDS changes, the code value of the frequency control raw signal FCS_raw may also change. For example, after the error time point tERR, the code value of the frequency control raw signal FCS_raw generated in the loop filter circuit 120 may temporarily rise. That is, if a glitch does not occur in the reference clock RCLK, the code value of the frequency control raw signal FCS_raw may be maintained constant; on the other hand, if a glitch occurs in the reference clock RCLK, an unintended change may occur in the code value of the frequency control raw signal FCS_raw after the error time point tERR.

If the digitally controlled oscillator 140 operates based on the frequency control raw signal FCS_raw, the frequency of the output clock OCLK may be determined based on the code value of the frequency control raw signal FCS_raw. For example, the frequency of the output clock OCLK may be linearly determined by the code value of the frequency control raw signal FCS_raw.

The frequency of the output clock OCLK may be maintained with a first frequency FREQ1 until a glitch occurs at the error time point tERR. The frequency of the output clock OCLK may temporarily increase after the error time point tERR. That is, if the phase locked loop 100 does not include a peaking suppression circuit 130, the frequency of the output clock OCLK may unintentionally fluctuate at the error time point tERR. In this case, an error may occur in the operation of the electronic device which operates based on the output clock OCLK.

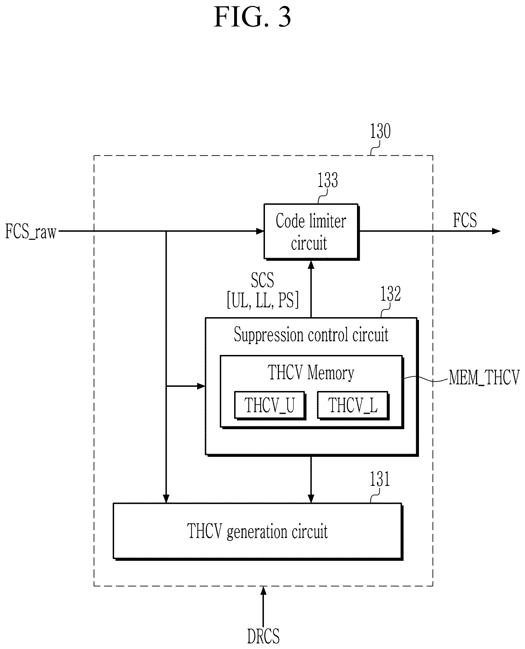

FIG. 3 is a block diagram showing the configuration of the peaking suppression circuit of FIG. 1 in more detail. Referring to FIGS. 1 to 3, the peaking suppression circuit 130 may include a code threshold value (THCV) generation circuit 131, a suppression control circuit 132, and a code limiter circuit 133.

The code threshold value generation circuit 131 may determine the code value suppression range for the frequency control signal FCS by monitoring the frequency control raw signal FCS_raw based on the divide ratio control signal DRCS. For example, the code threshold value generation circuit 131 may generate an upper code threshold value THCV_U and a lower code threshold value THCV_L, based on a fluctuation range of the frequency control raw signal FCS_raw in a specific time period after a sufficient time length has elapsed after a divide ratio value indicated by a divide ratio control signal DRCS has changed (i.e., in a time period where the output clock OCLK is in a steady state). The code threshold value generation circuit 131 may provide the upper code threshold value THCV_U and the lower code threshold value THCV_L to the suppression control circuit 132. The upper code threshold value THCV_U may be a greater value than the lower code threshold value THCV_L.

In an embodiment, a range between the upper code threshold value THCV_U and the lower code threshold value THCV_L may be referred to as a 'code value suppression range'.

The suppression control circuit 132 may receive the upper code threshold value THCV_U and the lower code threshold value THCV_L. The suppression control circuit 132 may include a code threshold value memory MEM_THCV (e.g., THCV memory). The suppression control circuit 132 may store the upper code threshold value THCV_U and the lower code threshold value THCV_L in the code threshold value memory MEM_THCV.

The suppression control circuit 132 may monitor the frequency control raw signal FCS_raw. More specifically, the suppression control circuit 132 may monitor whether the frequency control raw signal FCS_raw is out of the code value suppression range.

The suppression control circuit 132 may generate a suppression control signal SCS based on a monitoring result for the frequency control raw signal FCS_raw. For example, when the frequency control raw signal FCS_raw has a code value higher than the upper code threshold value THCV_U, the suppression control circuit 132 may generate a suppression control signal SCS indicating an upper limit UL. When the frequency control raw signal FCS_raw has a code value lower than the lower code threshold value THCV_L, the suppression control circuit 132 may generate a suppression control signal SCS indicating a lower limit LL. When the frequency control raw signal FCS_raw has a code value lower than the upper code threshold value THCV_U and higher than the lower code threshold value THCV_L, the suppression control circuit 132 may generate a suppression control signal SCS indicating a pass operation PS.

The code limiter circuit 133 may determine whether to limit the code value of the frequency control raw signal FCS_raw according to the suppression control signal SCS. For example, when the suppression control signal SCS indicates the upper limit UL, the code limiter circuit 133 may determine the code value of the frequency control signal FCS as the upper code threshold value THCV_U (i.e., regardless of the code value of the frequency control raw signal FCS_raw). When the suppression control signal SCS indicates the lower limit LL, the code limiter circuit 133 may determine the code value of the frequency control signal FCS as the lower code threshold value THCV_L (i.e., regardless of the code value of the frequency control raw signal FCS_raw). When the suppression control signal SCS indicates a pass operation PS, the code limiter circuit 133 may determine the code value of the frequency control signal FCS to be the same as the frequency control raw signal FCS_raw. In this manner, the code limiter circuit 133 may clamp the frequency control raw signal FCS_raw based on the upper code threshold value THCV_U and the lower code threshold value THCV_L according to the suppression control signal SCS.

In an embodiment, while the code threshold value generation circuit 131 monitors the frequency control raw signal FCS_raw for generating the upper code threshold value THCV_U and the lower code threshold value THCV_L, the suppression control circuit 132 may generate the suppression control signal SCS indicating the pass operation PS. That is, while the code threshold value generation circuit 131 monitors the frequency control raw signal FCS_raw, the frequency control raw signal FCS_raw may be identical to the frequency control signal FCS.

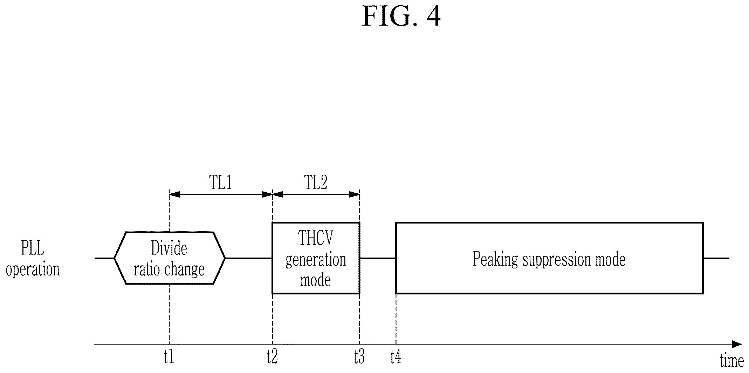

FIG. 4 is a timing diagram showing the operation of the phase locked loop of FIG. 1. The horizontal axis of FIG. 4 represents time. Referring to FIGS. 1 to 4, the divide ratio of the frequency divider circuit 150 may be changed at a first time point t1. For example, the divide ratio value indicated by the divide ratio control signal DRCS may be changed at the first time point t1.

Between a second time point t2 and a third time point t3, the phase locked loop 100 may operate in a code threshold value generation mode. For example, the code threshold value generation circuit 131 may determine the upper code threshold value THCV_U and the lower code threshold value THCV_L by monitoring the frequency control raw signal FCS_raw between the second time point t2 and the third time point t3. More specifically, the code threshold value generation circuit 131 may determine the upper code threshold value THCV_U and the lower code threshold value THCV_L based on a fluctuation range of the frequency control raw signal FCS_raw between the second time point t2 and the third time point t3.

The code threshold value generation circuit 131 may provide the upper code threshold value THCV_U and the lower code threshold value THCV_L to the suppression control circuit 132, and the suppression control circuit 132 may store the upper code threshold value THCV_U and the lower code threshold value THCV_L in the code threshold value memory MEM_THCV. That is, after the third time point t3, the upper code threshold value THCV_U and the lower code threshold value THCV_L may be stored in the code threshold value memory MEM_THCV.

In an embodiment, until the third time point t3, the suppression control circuit 132 may generate the suppression control signal SCS indicating the pass operation PS. In this case, the code limiter circuit 133 may perform the pass operation. Therefore, while the phase locked loop 100 operates in the code threshold value generation mode, the frequency control signal FCS may have the same code value as the frequency control raw signal FCS_raw.

The code threshold value generation circuit 131 may determine a time point at which a first time length TL1 has elapsed from the first time point t1 as a second time point t2. For example, the code threshold value generation circuit 131 may begin to monitor the frequency control raw signal FCS_raw from a time point where the first time length TL1 has elapsed from a time point where it recognizes that the divide ratio value indicated by the divide ratio control signal DRCS has changed.

In an embodiment, the first time length TL1 may be a time sufficiently long for signals generated by components of the phase locked loop 100 based on the changed divide ratio (e.g., output clock OCLK, phase difference signal PDS, frequency control raw signal FCS_raw, frequency control signal FCS) to enter a steady state.

In an embodiment, the first time length TL1 may be determined as a constant value. For example, the code threshold value generation circuit 131 may determine a time point, where the predetermined first time length TL1 has elapsed from the first time point t1, as a second time point t2. However, embodiments are not limited to the specific manner in which the first time length TL1 is determined. For example, the first time length TL1 may be determined based on a divide ratio indicated by the divide ratio control signal DRCS. For a more detailed example, the code threshold value generation circuit 131 may increase the first time length TL1, as the divide ratio indicated by the divide ratio control signal DRCS increases. In this case, the first time length TL1 may be determined by considering that a period of the output clock OCLK changes as the divide ratio indicated by the divide ratio control signal DRCS changes, so that a time length required to enter the code threshold value generation mode after the first time point t1 may be minimized (e.g., optimized).

The time interval between the second time point t2 and the third time point t3 may be a second time length TL2. That is, the phase locked loop 100 may operate in a code threshold value generation mode for the second time length TL2. For example, the code threshold value generation circuit 131 may determine the upper code threshold value THCV_U and the lower code threshold value THCV_L by monitoring the frequency control raw signal FCS_raw for the second time length TL2 which is determined before the second time point t2.

From a fourth time point t4 after the third time point t3, the phase locked loop 100 may operate in a peaking suppression mode. For example, the phase locked loop 100 may limit the frequency control signal FCS from going beyond the code value suppression range. In this regard, the phase locked loop 100 may clamp the code value of the frequency control signal FCS to remain between the upper code threshold value THCV_U and the lower code threshold value THCV_L. For a more detailed example, the suppression control circuit 132 may generate the suppression control signal SCS based on the monitoring result for the frequency control raw signal FCS_raw, and the code limiter circuit 133 may generate the frequency control signal FCS by clamping the frequency control raw signal FCS_raw in response to the suppression control signal SCS.

In an embodiment, the time interval between the third time point t3 and the fourth time point t4 may be very short. That is, the third time point t3 and the fourth time point t4 may be substantially the same time point. For example, the phase locked loop 100 may newly determine the code value suppression range whenever the divide ratio indicated by the divide ratio control signal DRCS changes. In this case, the phase locked loop 100 may be able to perform the peaking suppression operation from the third time point t3 when the code threshold values THCV corresponding to the changed divide ratio are newly generated.

For the sake of a more concise explanation, below, it is assumed that the peaking suppression circuit 130 is implemented to newly determine the code value suppression range whenever the divide ratio indicated by the divide ratio control signal DRCS is changed. In this case, the third time point t3 and the fourth time point t4 may be substantially the same time point. However, embodiments are not limited to a specific time interval between the third time point t3 and the fourth time point t4. That is, the time interval between the third time point t3 and the fourth time point t4 may be very long. For example, the suppression control circuit 132 may be implemented to control the code limiter circuit 133 based on a pre-determined code value suppression range. For a more detailed example, the divide ratio value indicated by the divide ratio control signal DRCS between the third time point t3 and the fourth time point t4 may be changed to a different value, and then changed back to the divide ratio of the first time point t1. In this case, because the suppression control circuit 132 may perform the peaking suppression operation at the fourth time point t4 based on the code value suppression range predetermined (e.g., determined between the second time point t2 and the third time point t3), the interval between the third time point t3 and the fourth time point t4 may become very long.

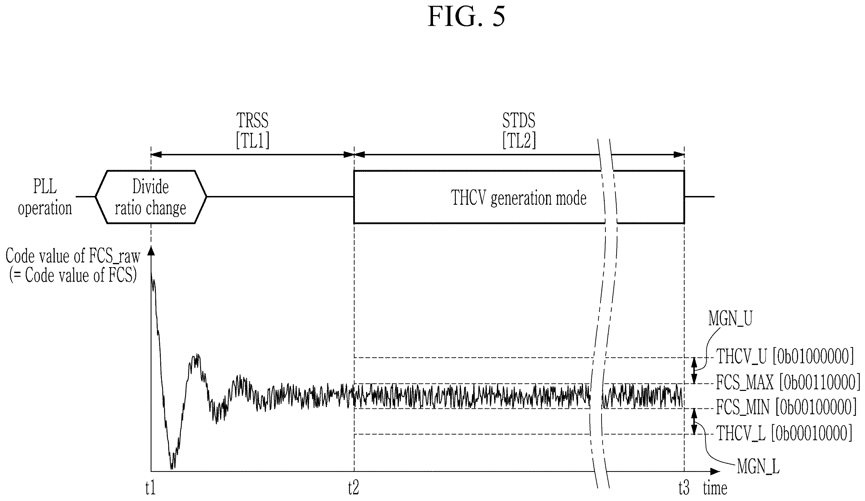

FIG. 5 is a drawing showing in more detail the operation of the threshold value generation circuit between the first and third time points of FIG. 4. Hereinafter, with reference to FIGS. 1 to 5, how the code threshold value generation circuit 131 generates the upper code threshold value THCV_U and the lower code threshold value THCV_L is described. The horizontal axis of FIG. 5 represents time. The vertical axis of the graph for the frequency control raw signal FCS_raw and the frequency control signal FCS illustrated in FIG. 5 represent a code value.

When the divide ratio of the frequency divider circuit 150 is changed at the first time point t1, the variability (e.g., volatility) of the frequency control raw signal FCS_raw (i.e., the frequency control signal FCS) may temporarily increase. The variability of this frequency control raw signal FCS_raw may be sufficiently small at the second time point t2.

The code threshold value generation circuit 131 may determine that the variability of the frequency control raw signal FCS_raw has become sufficiently small (i.e., less than a threshold value) after the second time point t2. That is, the code threshold value generation circuit 131 may identify the time period between the first time point t1 and the second time point t2 as a transient state TRSS of the frequency control raw signal FCS_raw, and may identify the time period after the second time point t2 as a steady state STDS of the frequency control raw signal FCS_raw. For example, the code threshold value generation circuit 131 may identify a time period of the first time length TL1 from the first time point t1 as the transient state TRSS of the frequency control raw signal FCS_raw, and may identify a time period of the second time length TL2 from the second time point t2 to as the steady state STDS of the frequency control raw signal FCS_raw.

Even if the frequency control raw signal FCS_raw enters the steady state STDS, the code value of the frequency control raw signal FCS_raw may continuously increase and decrease (e.g., fluctuate). For example, the code value of the frequency control raw signal FCS_raw may continuously change between the second time point t2 and the third time point t3 due to noise components.

The code threshold value generation circuit 131 may monitor a variation range (e.g., fluctuation range) of the frequency control raw signal FCS_raw between the second time point t2 and the third time point t3. For example, the code threshold value generation circuit 131 may identify a maximum value FCS_MAX and a minimum value FCS_MIN of the frequency control raw signal FCS_raw between the second time point t2 and the third time point t3.

The code threshold value generation circuit 131 may determine the upper code threshold value THCV_U and the lower code threshold value THCV_L based on the identified maximum value FCS_MAX and minimum value FCS_MIN. For example, the code threshold value generation circuit 131 may determine a value obtained by adding an upper margin MGN_U to the maximum value FCS_MAX as the upper code threshold value THCV_U, and may determine a value obtained by subtracting a lower margin MGN_L from the minimum value FCS_MIN as the lower code threshold value THCV_L.

For a more detailed example, the maximum value FCS_MAX may be "0b00110000", and the minimum value FCS_MIN may be "0b00100000". In this case, the code threshold value generation circuit 131 may determine "0b01000000", which is a value obtained by adding the upper margin MGN_U "0b00010000" to the maximum value FCS_MAX, as the upper code threshold value THCV_U; and may determine "0b00010000", which is a value obtained by subtracting the lower margin MGN_L "0b00010000" from "0b0010000", as the lower code threshold value THCV_L.

In an embodiment, the upper margin MGN_U and the lower margin MGN_L may be determined to be sufficiently large so that the frequency control raw signal FCS_raw does not go out of the code value suppression range while the phase locked loop 100 operates normally. Conversely, the upper margin MGN_U and the lower margin MGN_L may be determined to be sufficiently small so that the frequency control raw signal FCS_raw goes out of the code value suppression range while the phase locked loop 100 is operating abnormally (e.g., when a glitch occurs in the reference clock RCLK).

In an embodiment, the upper margin MGN_U may be determined to be the same value as the lower margin MGN_L. For example, the upper margin MGN_U and lower margin MGN_L may be determined based on a difference between the maximum value FCS_MAX and the minimum value FCS_MIN. However, embodiments are not limited thereto.

The code threshold value generation circuit 131 may provide the determined upper code threshold value THCV_U and lower code threshold value THCV_L to the suppression control circuit 132. The suppression control circuit 132 may store the upper code threshold value THCV_U and the lower code threshold value THCV_L in the code threshold value memory MEM_THCV. Therefore, after the third time point t3, the peaking suppression circuit 130 may be able to clamp the frequency control raw signal FCS_raw based on the upper code threshold value THCV_U and the lower code threshold value THCV_L.

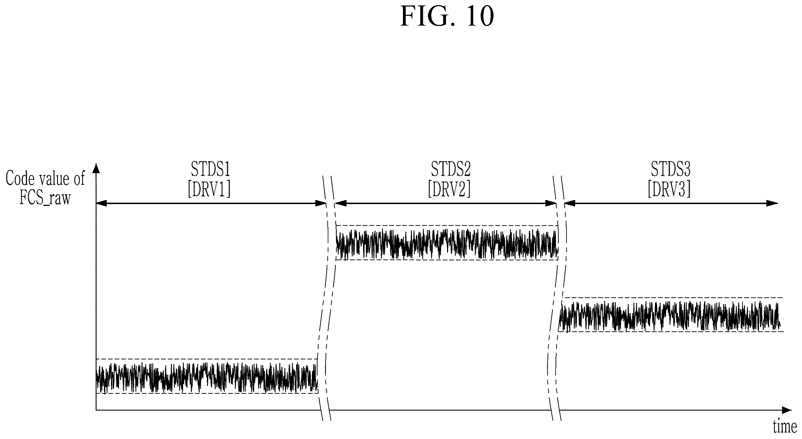

In an embodiment, the upper code threshold value THCV_U and the lower code threshold value THCV_L stored in the code threshold value memory MEM_THCV may correspond to the changed divide ratio at the first time point t1. For example, while the divide ratio value changed at the first time point t1 is maintained, the peaking suppression circuit 130 may clamp the frequency control raw signal FCS_raw based on the upper code threshold value THCV_U and the lower code threshold value THCV_L. On the other hand, if the divide ratio set at the first time point t1 is changed, the peaking suppression circuit 130 may require a different pair of upper code threshold values THCV_U and lower code threshold values THCV_L to clamp the frequency control raw signal FCS_raw. The manner in which the upper code threshold value THCV_U and the lower code threshold value THCV_L are determined for each divide ratio value is described in more detail with reference to FIG. 10 below.

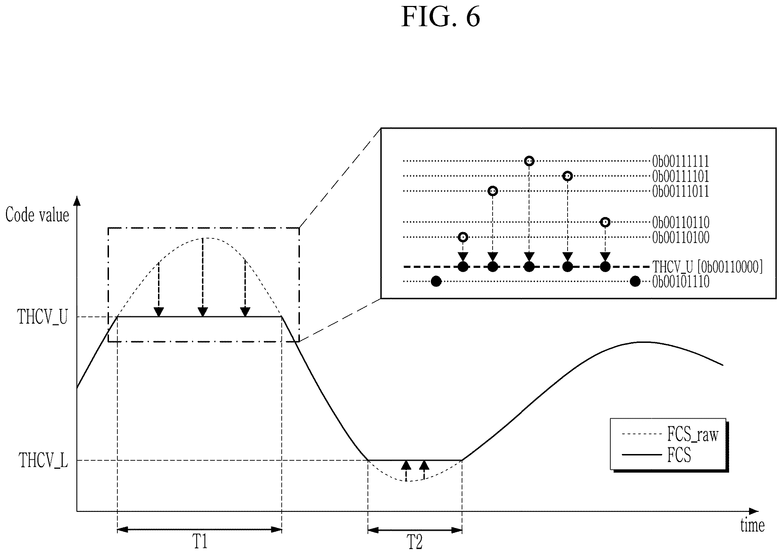

FIG. 6 is a diagram showing in more detail how the code limiter circuit of FIG. 3 performs a peaking suppression operation. The horizontal axis of FIG. 6 represents time, and the vertical axis represents code values.

Referring to FIGS. 1 to 6, after the third time point t3, the phase locked loop 100 may operate in the peaking suppression mode. In this case, the code limiter circuit 133 may perform the peaking suppression operation based on the upper code threshold value THCV_U and the lower code threshold value THCV_L stored in the code threshold value memory MEM_THCV.

The graph drawn in solid line in FIG. 6 represents the code value of the frequency control signal FCS, and the graph drawn in dotted line in FIG. 6 represents the code value of the frequency control raw signal FCS_raw.

During a first time period T1, the frequency control raw signal FCS_raw may have a code value greater than the upper code threshold value THCV_U. In this case, the suppression control circuit 132 may clamp, by generating a suppression control signal SCS indicating an upper limit UL, the code value of the frequency control signal FCS which is output by the code limiter circuit 133 to the upper code threshold value THCV_U.

For a more detailed example, the upper code threshold value THCV_U may be "0b00110000". The frequency control raw signal FCS_raw may be greater than the upper code threshold value THCV_U during the first time period T1. For example, during the first time period T1, the frequency control raw signal FCS_raw may be "0b00110100", "0b00110110", "0b00111011", "0b00111101", "0b00111101", "0b00111111", etc. In this case, the suppression control circuit 132 may generate the suppression control signal SCS indicating the upper limit UL, and the code limiter circuit 133 may determine the code value of the frequency control signal FCS as "0b00110000" (i.e., as the upper code threshold value THCV_U).

Conversely, during the second time period T2, the frequency control raw signal FCS_raw may have a code value less than the lower code threshold value THCV_L. In this case, the suppression control circuit 132 may clamp, by generating a suppression control signal SCS indicating a lower limit LL, the code value of the frequency control signal FCS which is output by the code limiter circuit 133 to the lower code threshold value THCV_L.

During time periods (e.g., time periods other than the first and second time periods T1, T2) in which the frequency control raw signal FCS_raw has a code value lower than the upper code threshold value THCV_U and higher than the lower code threshold value THCV_L, by generating a suppression control signal SCS indicating a pass operation PS, the suppression control circuit 132 may determine the code value of the frequency control signal FCS which is output by the code limiter circuit 133 to be the same as the code value of the frequency control raw signal FCS_raw. That is, in response to the suppression control signal SCS indicating the pass operation PS, the code limiter circuit 133 may provide the frequency control raw signal FCS_raw as the frequency control signal FCS to the digitally controlled oscillator 140.

For a more concise explanation, FIG. 6 illustrates an embodiment in which a code limiter circuit 133 limits the range of a frequency control signal FCS between the upper code threshold value THCV_U and the lower code threshold value THCV_L, but embodiments are not limited thereto. For example, if the frequency control raw signal FCS_raw is greater than the upper code threshold value THCV_U, the suppression control circuit 132 may generate a suppression control signal SCS indicating an upper limit UL. In this case, the code limiter circuit 133 may determine the code value of the frequency control signal FCS to a value other than the upper code threshold value THCV_U. In this manner, the code limiter circuit 133 may clamp the frequency control signal FCS to values other than the upper code threshold value THCV_U and the lower code threshold value THCV_L.

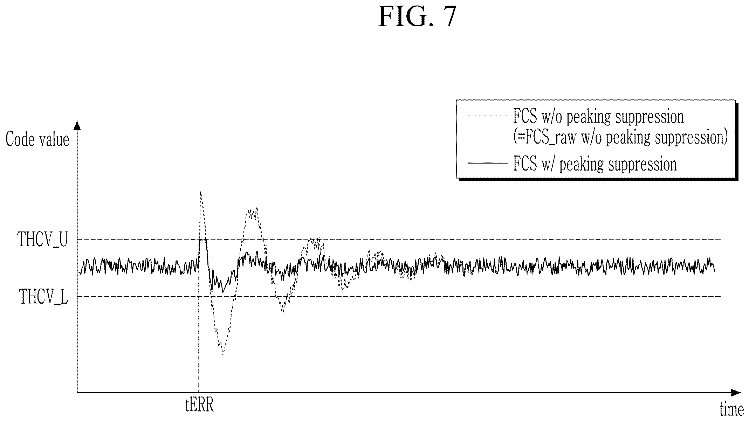

FIG. 7 is a diagram showing the effect of peaking suppression according to an embodiment. The horizontal axis of FIG. 7 represents time and the vertical axis represents code values. Referring to FIGS. 1 to 7, the phase locked loop 100 may operate in the peaking suppression mode. For example, the peaking suppression circuit 130 may perform a peaking suppression operation based on the upper code threshold value THCV_U and the lower code threshold value THCV_L.

The graph illustrated in dotted line in FIG. 7 represents a frequency control signal FCS when the peaking suppression circuit 130 does not perform the peaking suppression operation (e.g., when the suppression control signal SCS always indicates a pass operation PS, or when the peaking suppression circuit 130 is not included between the loop filter circuit 120 and the digitally controlled oscillator 140). In this regard, the graph depicted by the dotted line represents the frequency control raw signal FCS_raw when the peaking suppression circuit 130 does not perform the peaking suppression operation.

The graph drawn with solid line in FIG. 7 represents a frequency control signal FCS when the peaking suppression circuit 130 performs the peaking suppression operation. The graph drawn with a solid line represents a frequency control signal FCS when the peaking suppression circuit 130 performs the peaking suppression operation in a manner described above with reference to FIG. 6.

At the error time point tERR, a glitch may occur in the reference clock RCLK. That is, a glitch may occur in the reference clock RCLK while the phase locked loop 100 operates in peaking suppression mode.

Referring to the graph shown in the dotted line, due to the glitch in the reference clock RCLK, the variability of the frequency control raw signal FCS_raw (and the frequency control signal FCS) may significantly increase after the error time point tERR. That is, when the peaking suppression circuit 130 does not perform the peaking suppression operation, the code value of the frequency control raw signal FCS_raw may be higher than the upper code threshold value THCV_U or be lower than the lower code threshold value THCV_L. In this case, the frequency of the output clock OCLK may fluctuate excessively.

On the other hand, referring to the graph shown in the solid line, even if a glitch occurs in the reference clock RCLK, the fluctuation range of the frequency control signal FCS may be limited between the upper code threshold value THCV_U and the lower code threshold value THCV_L. That is, according to an embodiment, even if the phase difference signal PDS and the frequency control raw signal FCS_raw fluctuate significantly due to the glitch of the reference clock RCLK, the fluctuation range of the frequency control signal FCS may be minimized. In this case, unintended fluctuations in the frequency of the output clock OCLK may be minimized.

In addition, referring to the both graphs drawn with dotted lines and the graphs drawn with solid lines together, the variability of the frequency control signal FCS may be alleviated more quickly when the peaking suppression circuit 130 performs the peaking suppression operation. Therefore, according to an embodiment, the time required for the frequency of the output clock OCLK to recover to normal after the glitch occurs in the reference clock RCLK may be minimized.

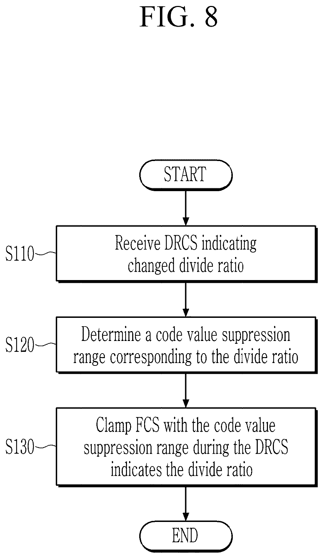

FIG. 8 is a flowchart showing the operation of a phase locked loop according to an embodiment. Referring to FIGS. 1 to 8, at operation S110, the phase locked loop 100 may receive a divide ratio control signal DRCS indicating a changed divide ratio. For example, the peaking suppression circuit 130 may recognize a change of the divide ratio value indicated by the divide ratio control signal DRCS.

At operation S120, the phase locked loop 100 may determine a code value suppression range corresponding to the divide ratio. For example, the peaking suppression circuit 130 may determine the code value suppression range corresponding to the divide ratio.

At operation S130, while the divide ratio indicated by the divide ratio control signal DRCS is maintained, the phase locked loop 100 may clamp the code value of the frequency control signal FCS within the code value suppression range. For example, the peaking suppression circuit 130 may generate the frequency control signal FCS by clamping the frequency control raw signal FCS_raw based on the code value suppression range.

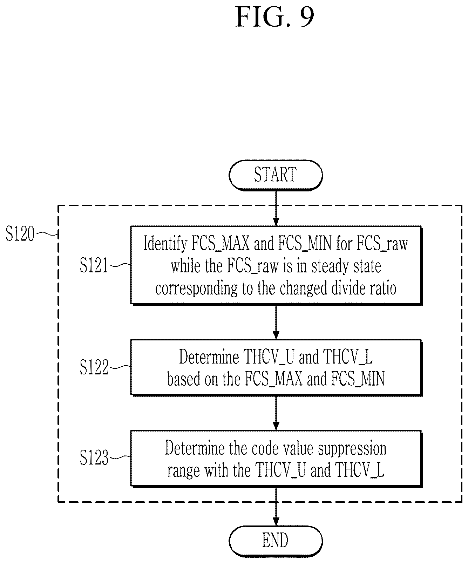

FIG. 9 is a flowchart showing operation S120 of FIG. 8 in more detail. Referring to FIGS. 1 to 9, operation S120 may include operations S121 to S123 below.

At operation S121, the peaking suppression circuit 130 may identify a maximum value FCS_MAX and a minimum value FCS_MIN for the frequency control raw signal FCS_raw while the frequency control raw signal FCS_raw is in a steady state corresponding to the changed divide ratio. For example, the peaking suppression circuit 130 may identify the maximum value FCS_MAX and the minimum value FCS_MIN of the frequency control raw signal FCS_raw for the second time length TL2 after the frequency control raw signal FCS_raw enters a steady state corresponding to the changed divide ratio.

At operation S122, the peaking suppression circuit 130 may determine the upper code threshold value THCV_U and the lower code threshold value THCV_L based on the maximum value FCS_MAX and the minimum value FCS_MIN.

At operation S123, the peaking suppression circuit 130 may determine the interval between the upper code threshold value THCV_U and the lower code threshold value THCV_L as the code value suppression range corresponding to the changed divide ratio.

In an embodiment, the phase locked loop 100 may perform operations S121 and S122 whenever the operation S110 is performed. That is, the peaking suppression circuit 130 may identify the maximum value FCS_MAX and minimum value FCS_MIN for the frequency control raw signal FCS_raw over a specified time length, whenever the divide ratio indicated by the divide ratio control signal DRCS is changed. However, embodiments are not limited thereto. For example, the phase locked loop 100 may record the determined upper code threshold value THCV_U and lower code threshold value THCV_L (or code value suppression range) by performing operations S121 and S122 while the divide ratio control signal DRCS indicates a specific divide ratio. In this case, the peaking suppression circuit 130 may determine the code value suppression range based on the recorded upper code threshold value THCV_U and lower code threshold value THCV_L, instead of performing operations S121 and S122 repeatedly when the divide ratio control signal DRCS is changed to indicate the divide ratio again.

FIG. 10 is a diagram showing a frequency control raw signal corresponding to a divide ratio control signal indicating different divide ratio values. The horizontal axis of FIG. 10 represents time, and the vertical axis represents code values.

Referring to FIGS. 1 to 10, the code value of the frequency control raw signal FCS_raw may vary depending on the divide ratio value DRV indicated by the divide ratio control signal DRCS. For example, code values of the frequency control raw signal FCS_raw during a first steady state STDS1 corresponding to a case where the divide ratio control signal DRCS indicates a first divide ratio value DRV1, code values of the frequency control raw signal FCS_raw during a second steady state STDS2 corresponding to a case where the divide ratio control signal DRCS indicates a second divide ratio value DRV2, and code values of the frequency control raw signal FCS_raw during a third steady state STDS3 corresponding to a case where the divide ratio control signal DRCS indicates a third divide ratio value DRV3 may correspond to different ranges.

That is, when the divide ratio value DRV indicated by the divide ratio control signal DRCS changes, a fluctuation range of code values of the frequency control raw signal FCS_raw while the frequency control raw signal FCS_raw is in a steady state corresponding to the changed divide ratio value DRV may change. In this regard, when the divide ratio value DRV indicated by the divide ratio control signal DRCS is changed, the pair of maximum value FCS_MAX and minimum value FCS_MIN (e.g., a variation range of the frequency control raw signal FCS_raw in case of glitch does not occur in the reference clock RCLK) may change significantly.

Therefore, in order for the peaking suppression circuit 130 to efficiently perform the peaking suppression operation, the peaking suppression circuit 130 may need to individually determine code value suppression range for each divide ratio value DRV indicated by the divide ratio control signal DRCS.

For example, the peaking suppression circuit 130 may determine a code value suppression range based on the maximum value FCS_MAX and the minimum value FCS_MIN of the frequency control raw signal FCS_raw for a specified time length (e.g., the second time length TL2) whenever the divide ratio value DRV indicated by the divide ratio control signal DRCS changes. An example in which the peaking suppression circuit 130 newly determines the code value suppression range whenever the divide ratio value DRV indicated by the divide ratio control signal DRCS changes has been described above with reference to FIGS. 1 to 9, so a repeated description thereof will be omitted.

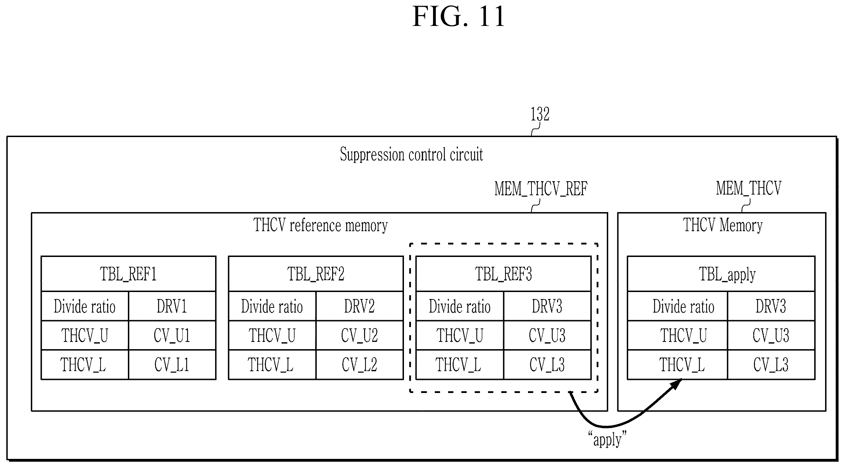

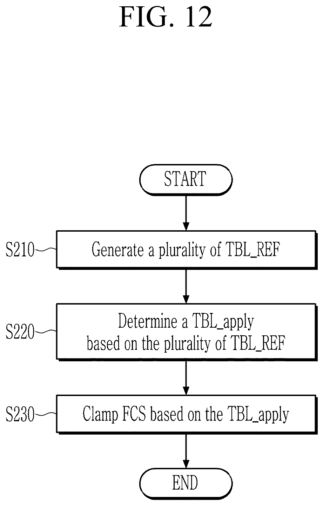

As another example, the peaking suppression circuit 130 may predetermine a code value suppression range for each available divide ratio value DRV that can be indicated by the divide ratio control signal DRCS. In this case, the peaking suppression circuit 130 may perform a peaking suppression operation based on a predetermined code value suppression range whenever the divide ratio value DRV indicated by the divide ratio control signal DRCS changes. An embodiment in which the peaking suppression circuit 130 predetermines a code value suppression range for each of the divide ratio values DRV is described in more detail with reference to FIGS. 11 and 12 below.

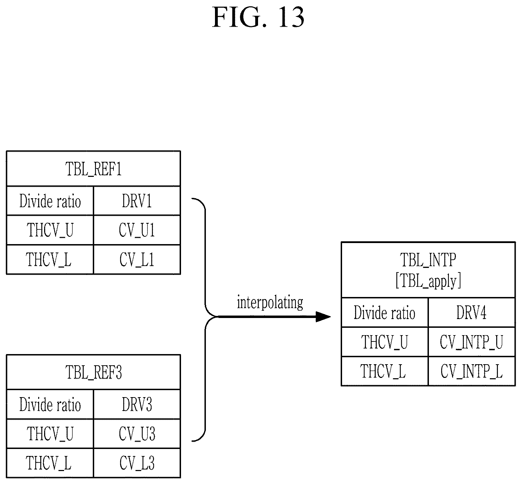

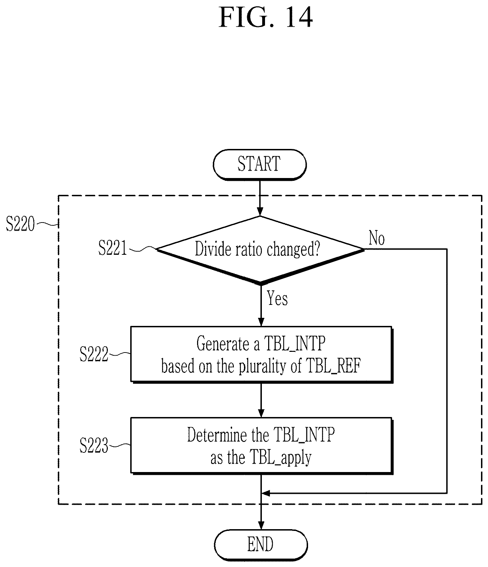

However, depending on which electronic device the phase locked loop 100 is mounted on, the divide ratio value DRV that the divide ratio control signal DRCS can indicate may vary variously. In this case, the phase locked loop 100 may predetermine a code value suppression range only for some (e.g., several) divide ratio values DRV that can be indicated by the divide ratio control signal DRCS, and may perform a peaking suppression operation based on an interpolated code value suppression range generated by interpolating the pre-determined code value suppression ranges whenever the divide ratio value DRV indicated by the divide ratio control signal DRCS changes. An embodiment in which the peaking suppression circuit 130 performs a peaking suppression operation based on the interpolation code value suppression range is described in more detail with reference to FIGS. 13 and 14 below.

FIG. 11 is a block diagram showing in more detail how the peaking suppression circuit predetermines the code value suppression range for each of a plurality of divide ratio values. Referring to FIGS. 1 to 11, the suppression control circuit 132 may include the code threshold value memory MEM_THCV and a code threshold value reference memory MEM_THCV_REF.

The code threshold value reference memory MEM_THCV_REF may include a plurality of reference tables TBL_REF. For example, the code threshold value reference memory MEM_THCV_REF may include first to third reference tables TBL_REF1 to TBL_REF3.

Each of the first to third reference tables TBL_REF1 to TBL_REF3 may correspond to different divide ratio values DRV that the divide ratio control signal DRCS may indicate. For example, the first to third reference tables TBL_REF1 to TBL_REF3 may correspond to the first to third divide ratio values DRV1 to DRV3, respectively.

Each of the first to third reference tables TBL_REF1 to TBL_REF3 may include an upper code threshold value THCV_U and a lower code threshold value THCV_L for the corresponding divide ratio value. That is, the first to third reference tables TBL_REF1 to TBL_REF3 may include an upper code threshold value THCV_U and a lower code threshold value THCV_L generated in the manner described above with reference to FIG. 5 while the divide ratio control signal DRCS indicates the first to third divide ratio values DRV1 to DRV3, respectively. For example, a first reference table TBL_REF1 may include an upper code threshold value THCV_U "CV_U1" and a lower code threshold value THCV_L "CV_L1"; a second reference table TBL_REF2 may include an upper code threshold value THCV_U "CV_U2" and a lower code threshold value THCV_L "CV_L2"; and a third reference table TBL_REF3 may include an upper code threshold value THCV_U "CV_U3" and a lower code threshold value THCV_L "CV_L3".

In an embodiment, the code threshold value generation circuit 131 may store each of the first to third reference tables TBL_REF1 to TBL_REF3 in the code threshold value reference memory MEM_THCV_REF during the initial setup stage of the phase locked loop 100. For example, when a phase locked loop 100 is produced, or when an electronic device including the phase locked loop 100 is booted up, the code threshold value generation circuit 131 may generate the first to third reference tables TBL_REF1 to TBL_REF3. However, embodiments are not limited to the specific time at which each of the first to third reference tables TBL_REF1 to TBL_REF3 is generated.

The code threshold value memory MEM_THCV may store the upper code threshold value THCV_U and the lower code threshold value THCV_L in a form of an application table TBL_apply. The upper code threshold value THCV_U and the lower code threshold value THCV_L stored in the code threshold value memory MEM_THCV may be used for the peaking suppression operation of the code limiter circuit 133.

The application table TBL_apply may be determined based on a plurality of reference tables TBL_REF stored in the code threshold value reference memory MEM_THCV_REF. For example, the suppression control circuit 132 may determine a reference table TBL_REF corresponding to a divide ratio value DRV indicated by a divide ratio control signal DRCS as the application table TBL_apply.

For a more detailed example, when the divide ratio value indicated by the divide ratio control signal DRCS is the third divide ratio value DRV3, the suppression control circuit 132 may determine the third reference table TBL_REF3 as the application table TBL_apply. That is, the suppression control circuit 132 may store the upper code threshold value THCV_U "CV_U3" and the lower code threshold value THCV_L "CV_L3" in the code threshold value memory MEM_THCV.

In an embodiment, each of the plurality of reference tables TBL_REF may be referenced as 'a threshold value reference table', and the application table TBL_apply may be referenced as 'a threshold value application table'. However, embodiments are not limited to these terms.

For brevity, although FIG. 12 illustrates that the code threshold value reference memory MEM_THCV_REF and the code threshold value memory MEM_THCV are separate components, embodiments are not limited thereto. For example, the code threshold value memory MEM_THCV may refer to a proportion of the code threshold value reference memory MEM_THCV_REF. In this case, instead of newly storing the reference table TBL_REF corresponding to the divide ratio value DRV indicated by the divide ratio control signal DRCS in the code threshold value memory MEM_THCV, the suppression control circuit 132 may determine a memory area of the code threshold value reference memory MEM_THCV_REF, where the reference table TBL_REF corresponding to the divide ratio value DRV indicated by the divide ratio control signal DRCS stored, as the code threshold value memory MEM_THCV. That is, embodiments are not limited to specific implementation schemes of the code threshold value reference memory MEM_THCV_REF and the code threshold value memory MEM_THCV.

FIG. 12 is a flowchart showing the operation of a phase locked loop according to an embodiment. Referring to FIGS. 1 to 12, at operation S210, the phase locked loop 100 may generate a plurality of reference tables TBL_REF. For example, the divide ratio value DRV indicated by the divide ratio control signal DRCS may be changed sequentially with a plurality of times. In this case, the peaking suppression circuit 130 may generate a reference table TBL_REF for each of the divide ratio values indicated by the divide ratio control signal DRCS in a similar manner to that described above with reference to FIG. 5. The peaking suppression circuit 130 may store the plurality of reference tables TBL_REF in the code threshold value reference memory MEM_THCV_REF.

At operation S220, the phase locked loop 100 may determine an application table TBL_apply based on the plurality of reference tables TBL_REF. For example, the suppression control circuit 132 may determine the reference table TBL_REF corresponding to a divide ratio value indicated by the divide ratio control signal DRCS as the application table TBL_apply. That is, the suppression control circuit 132 may store the upper code threshold value THCV_U and the lower code threshold value THCV_L corresponding to the divide ratio value indicated by the divide ratio control signal DRCS, in the code threshold value memory MEM_THCV.

At operation S230, the phase locked loop 100 may clamp the code value of the frequency control signal FCS based on the application table TBL_apply. For example, the peaking suppression circuit 130 may clamp the frequency control signal FCS with the upper code threshold value THCV_U and the lower code threshold value THCV_L stored in the code threshold value memory MEM_THCV.

FIG. 13 is a block diagram showing in more detail how the peaking suppression circuit interpolates predetermined code value suppression ranges. Referring to FIGS. 1 to 13, the code threshold value reference memory MEM_THCV_REF may include a plurality of reference tables TBL_REF. For example, the code threshold value reference memory MEM_THCV_REF may include first to third reference tables TBL_REF1 to TBL_REF3 corresponding to the first to third divide ratio values DRV1 to DRV3, respectively.

The divide ratio value DRV indicated by the divide ratio control signal DRCS may be a fourth divide ratio value DRV4. However, the code threshold value reference memory MEM_THCV_REF may not include a reference table TBL_REF corresponding to the fourth divide ratio value DRV4. In this case, the peaking suppression circuit 130 may generate an interpolation reference table TBL_INTP based on reference tables TBL_REF corresponding to divide ratio values similar to the fourth divide ratio value DRV4.

For example, the fourth divide ratio value DRV4 may be a value between the first divide ratio value DRV1 and the third divide ratio value DRV3. In this case, the peaking suppression circuit 130 may generate an interpolation reference table TBL_INTP based on the first reference table TBL_REF1 and the third reference table TBL_REF3.

For a more detailed example, the suppression control circuit 132 may generate the upper code threshold value THCV_U of the interpolation reference table TBL_INTP based on the upper code threshold values THCV_U included in the first reference table TBL_REF1 and the third reference table TBL_REF3; and may generate the lower code threshold value THCV_L of the interpolation reference table TBL_INTP based on the lower code threshold values THCV_L included in the first reference table TBL_REF1 and the third reference table TBL_REF3. That is, the suppression control circuit 132 may generate "CV_INTP_U" by interpolating "CV_U1" and "CV_U3", and may generate "CV_INTP_L" by interpolating "CV_L1" and "CV_L3".

The suppression control circuit 132 may determine the interpolation reference table TBL_INTP as the application table TBL_apply. In this case, because the code threshold value reference memory MEM_THCV_REF may not store the reference table TBL_REF corresponding to the fourth divide ratio value DRV4, the code threshold value reference memory MEM_THCV_REF may be implemented with a smaller capacity; and because the upper code threshold value THCV_U and the lower code threshold value THCV_L corresponding to the fourth divide ratio value DRV4 may be determined even if the code threshold value generation circuit 131 does not monitor the frequency control raw signal FCS_raw separately, the peaking suppression circuit 130 may perform quickly (e.g., with small delay) the peaking suppression operation after the divide ratio value indicated by the divide ratio control signal DRCS is changed.

FIG. 14 is a flowchart showing operation S220 of FIG. 12 in more detail according to an embodiment. Referring to FIGS. 1 to 14, operation S220 may include operations S221 to S223 below.

At operation S221, the phase locked loop 100 may determine whether the divide ratio value has changed. For example, the suppression control circuit 132 may detect a change in the divide ratio value indicated by the divide ratio control signal DRCS.

At operation S222, the phase locked loop 100 may generate an interpolation reference table TBL_INTP based on a plurality of reference tables TBL_REF. For example, the suppression control circuit 132 may generate an interpolation reference table TBL_INTP by interpolating one or more reference tables TBL_REF.

At operation S223, the phase locked loop 100 may determine the interpolation reference table TBL_INTP as the application table TBL_apply. For example, the suppression control circuit 132 may store the interpolation reference table TBL_INTP in the code threshold value memory MEM_THCV.

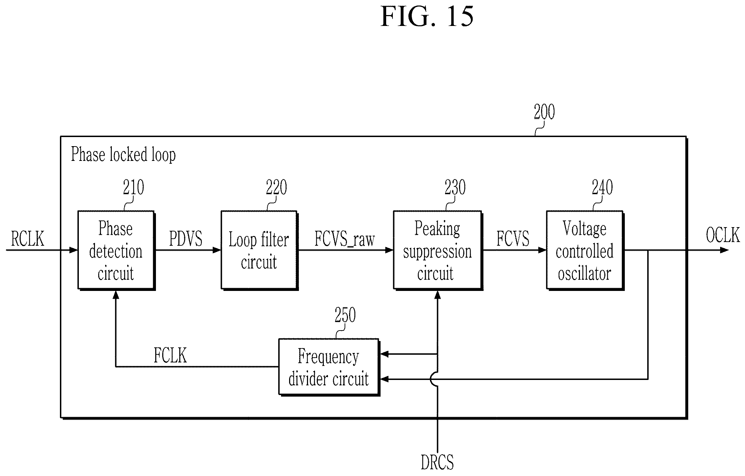

FIG. 15 is a block diagram showing a phase locked loop according to an embodiment. Referring to FIGS. 1 to 15, the phase locked loop 200 may be implemented as an analog phase locked loop. The phase locked loop 200 may generate an output clock OCLK according to a reference clock RCLK and a divide ratio control signal DRCS.

The phase locked loop 200 may include a phase detection circuit 210, a loop filter circuit 220, a peaking suppression circuit 230, a voltage controlled oscillator 240, and a frequency divider circuit 250. In the following, for a more concise explanation, the differences between the phase locked loop 200 and the phase locked loop 100 will be mainly explained.

The phase detection circuit 210 may receive a feedback clock FCLK and the reference clock RCLK. The phase detection circuit 210 may generate a phase difference voltage signal PDVS based on the phase difference between the feedback clock FCLK and the reference clock RCLK.

The loop filter circuit 220 may receive the phase difference voltage signal PDVS. The loop filter circuit 220 may generate a frequency control raw voltage signal FCVS_raw based on the phase difference voltage signal PDVS.

The peaking suppression circuit 230 may receive the frequency control raw voltage signal FCVS_raw and the divide ratio control signal DRCS. The peaking suppression circuit 230 may generate a frequency control voltage signal FCVS based on the frequency control raw voltage signal FCVS_raw and the divide ratio control signal DRCS.

The peaking suppression circuit 230 may generate a frequency control voltage signal FCVS by clamping the frequency control raw voltage signal FCVS_raw based on the divide ratio control signal DRCS. More specifically, the peaking suppression circuit 130 may generate the frequency control voltage signal FCVS by clamping the frequency control raw voltage signal FCVS_raw within a certain voltage range according to the divide ratio value indicated by the divide ratio control signal DRCS.

In an embodiment, the peaking suppression circuit 230 may be implemented to clamp the frequency control raw voltage signal FCVS_raw based on various types of electronic circuits such as a buck converter, a comparator, and the like. However, embodiments are not limited to a specific implementation method of the peaking suppression circuit 230.

The voltage controlled oscillator 240 may generate the output clock OCLK according to the voltage level of the frequency control voltage signal FCVS. For example, the voltage controlled oscillator 240 may generate the output clock OCLK having a frequency corresponding to the voltage level of the frequency control voltage signal FCVS.

The frequency divider circuit 250 may receive the divide ratio control signal DRCS and the output clock OCLK. Similar to the frequency divider circuit 150, the frequency divider circuit 250 may generate a feedback clock FCLK by dividing the output clock OCLK based on the divide ratio value indicated by the divide ratio control signal DRCS.

That is, embodiments are not limited to a specific implementation method of a phase locked loop. For example, embodiments are not limited to whether the phase locked loop is implemented in an analog or digital scheme.

In an embodiment, signals generated by components of the phase locked loop 200 may correspond to signals generated by components of the phase locked loop 100. From this perspective, the phase difference voltage signal PDVS may be referred to as a phase difference signal; the frequency control raw voltage signal FCVS_raw may be referred to as a frequency control raw signal; and the frequency control voltage signal FCVS may be referred to as a frequency control signal. However, embodiments are not limited to these terms.

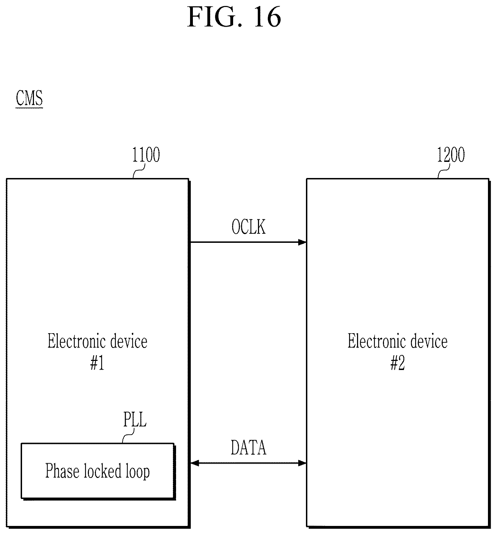

FIG. 16 is a block diagram showing a communication system according to an embodiment. Referring to FIGS. 1 to 16, a communication system CMS may include a first electronic device 1100 and a second electronic device 1200.

The first electronic device 1100 may include a phase locked loop PLL. The phase locked loop PLL may generate an output clock OCLK. The first electronic device 1100 may provide the output clock OCLK to the second electronic device 1200.

The second electronic device 1200 may operate according to the output clock OCLK. For example, the second electronic device 1200 may exchange data with the first electronic device 1100 based on the output clock OCLK.

In an embodiment, the second electronic device 1200 may be implemented as a memory device that operates according to the output clock OCLK, and the first electronic device 1100 may be implemented as a host device that controls the second electronic device 1200. However, embodiments are not limited thereto.

The phase locked loop PLL may be implemented as the phase locked loop 100 as previously described with reference to FIGS. 1 to 14 or as the phase locked loop 200 as previously described with reference to FIG. 15. In this case, unintended frequency fluctuations of the output clock OCLK may be minimized. In this case, the operation error of the second electronic device 1200 due to unintended frequency fluctuation of the output clock OCLK may be minimized.

In particular, when the second electronic device 1200 is implemented as a memory device, the possibility of an error occurring in a write operation or a read operation for the second electronic device 1200 due to the unintended frequency fluctuation of the output clock OCLK may be minimized. In this case, the operational stability of the second electronic device 1200 may be improved.

For a more concise explanation, FIG. 16 illustrates an example in which the first electronic device 1100 and the second electronic device 1200 exchange data with each other based on the output clock OCLK, but embodiments are not limited to the specific manner in which the output clock OCLK is utilized. For example, the first electronic device 1100 may utilize the output clock OCLK in various ways, such as wirelessly communicating with another electronic device based on the output clock OCLK, or determining a time point to control another electronic device based on the output clock OCLK.

While aspects of embodiments have been described, it will be apparent to those of ordinary skill in the art that various changes and modifications may be made thereto without departing from the scope of the present disclosure as set forth in the following claims.

Embodiments are set out in the following clauses:
Clause 1. A phase locked loop, comprising:
   an oscillator configured to generate an output clock according to a frequency control signal;
   a frequency divider circuit configured to divide the output clock based on a divide ratio value indicated by a divide ratio control signal; and
   a peaking suppression circuit configured to limit a fluctuation range of the frequency control signal according to the divide ratio value.
Clause 2. The phase locked loop of clause 1, wherein the frequency divider circuit operates based on a first divide ratio value during a first time period, and a second divide ratio value during a second time period, and
   wherein the peaking suppression circuit is further configured to:
   clamp the frequency control signal within a first suppression range during the first time period, and
   clamp the frequency control signal within a second suppression range during the second time period.
Clause 3. The phase locked loop of clause 2, wherein the frequency divider circuit operates based on the first divide ratio value during a third time period, and
   wherein the peaking suppression circuit is further configured to clamp the frequency control signal within a third suppression range during the third time period where the frequency divider circuit operates based on the first divide ratio value.
Clause 4. The phase locked loop of clause 2 or clause 3, wherein the peaking suppression circuit is further configured to determine the first suppression range based on a variation range of the frequency control signal during a fourth time period, and
   wherein the fourth time period is prior to the first time period and after a first time point when the frequency divider circuit begins to indicate the first divide ratio value.

## Claims

1. A phase locked loop (100), comprising:
a digitally controlled oscillator (140) configured to generate an output clock (OCLK) according to a frequency control signal (FCS);
a frequency divider circuit (150) configured to generate a feedback clock (FCLK) by frequency dividing the output clock (OCLK) based on a first divide ratio value (DRV1);
a phase detection circuit (110) configured to generate a phase difference signal (PDS) according to a phase difference between the feedback clock (FCLK) and an externally provided reference clock (RCLK);
a loop filter circuit (120) configured to generate a frequency control raw signal (FCS_raw) based on the phase difference signal (PDS); and
a peaking suppression circuit (130) configured to generate the frequency control signal (FCS) by limiting a fluctuation range of the frequency control raw signal (FCS_raw).

2. The phase locked loop (100) of claim 1, wherein the peaking suppression circuit (130) comprises:
a suppression control circuit (132) configured to manage a first threshold value (THCV_U) and a second threshold value (THCV_L); and
a code limiter circuit (133) configured to generate the frequency control signal (FCS) by clamping the frequency control raw signal (FCS_raw) based on the first threshold value (THCV_U) and the second threshold value (THCV_L).

3. The phase locked loop (100) of claim 2, wherein the suppression control circuit (132) is further configured to, by controlling the code limiter circuit (133):
based on a code value of the frequency control raw signal (FCS_raw) being greater than the first threshold value (THCV_U), determine a code value of the frequency control signal (FCS) as the first threshold value (THCV_U),
based on the code value of the frequency control raw signal (FCS_raw) being less than the second threshold value (THCV_L), determine the code value of the frequency control signal (FCS) as the second threshold value (THCV_L), and
based on the code value being between the first threshold value (THCV_U) and the second threshold value (THCV_L) of the frequency control raw signal (FCS_raw), determine the code value of the frequency control signal (FCS) same as the code value of the frequency control raw signal (FCS_raw).

4. The phase locked loop (100) of claim 2 or claim 3, wherein the frequency divider circuit (150) is configured to operate based on the first divide ratio value (DRV1) during a first time period, and
wherein the peaking suppression circuit (130) further comprises a threshold value generation circuit (131) configured to generate the first threshold value (THCV_U) and the second threshold value (THCV_L) by monitoring the frequency control raw signal (FCS_raw) during the first time period.

5. The phase locked loop (100) of claim 4, wherein the frequency control raw signal (FCS_raw) is configured to be in a steady state corresponding to the first divide ratio value (DRV1) during the first time period.

6. The phase locked loop (100) of claim 5, wherein the frequency divider circuit (150) is further configured to change a divide ratio (DRV) to the first divide ratio value (DRV1) according to a divide ratio control signal (DRCS) indicating the first divide ratio value (DRV1), and
wherein the threshold value generation circuit (131) is further configured to generate, according to the divide ratio control signal (DRCS), the first threshold value (THCV_U) and the second threshold value (THCV_L) by monitoring the frequency control raw signal (FCS_raw) during the first time period.

7. The phase locked loop (100) of claim 6, wherein the threshold value generation circuit (131) is further configured to determine a second time point (t2), where a first time length (TL1) has elapsed from a first time point (t1) at which the divide ratio control signal (DRCS) initially indicates the first divide ratio value (DRV1), as a beginning point of the first time period.

8. The phase locked loop (100) of claim 7, wherein the threshold value generation circuit (131) is further configured to determine the first time length (TL1) based on the first divide ratio value (DRV1).

9. The phase locked loop (100) of any of claims 4-8, wherein the threshold value generation circuit (131) is further configured to: generate the first threshold value (THCV_U) and the second threshold value (THCV_L) based on a maximum value (FCS_MAX) and a minimum value (FCS_MIN) of the frequency control raw signal (FCS_raw) during the first time period.

10. The phase locked loop (100) of claim 9, wherein the maximum value (FCS_MAX) and the minimum value (FCS_MIN) are between the first threshold value (THCV_U) and the second threshold value (THCV_L).

11. The phase locked loop (100) of any of claims 2-10, wherein the suppression control circuit (132) is further configured to:
store a first reference table (TBL_REF1) corresponding to a case where the frequency divider circuit (150) operates based on the first divide ratio value (DRV1), and
determine the first threshold value (THCV_U) and the second threshold value (THCV_L) based on the first reference table (TBL_REF1).

12. The phase locked loop (100) of claim 2, wherein the suppression control circuit (132) is further configured to generate the first threshold value (THCV_U) and the second threshold value (THCV_L) based on:
a second reference table (TBL_REF2) corresponding to a case where the frequency divider circuit (150) operates based on a second divide ratio value (DRV2), and
a third reference table (TBL_REF3) corresponding to a case where the frequency divider circuit (150) operates based on a third divide ratio value (DRV3).

13. The phase locked loop (100) of claim 12, wherein the second reference table (TBL_REF2) comprises a third threshold value and a fourth threshold value,
wherein the third reference table comprises a fifth threshold value and a sixth threshold value, and
wherein the suppression control circuit (132) is further configured to generate the first threshold value (THCV_U) based on the third threshold value and the fifth threshold value, and to identify the second threshold value (THCV_L) based on the fourth threshold value and the sixth threshold value.

14. An operation method of a phase locked loop (100) including a digitally controlled oscillator (140) generating an output clock (OCLK) according to a frequency control signal (FCS), the operation method comprising:
receiving a divide ratio control signal (DRCS) indicating a first divide ratio value (DRV1);
determining a first code value suppression range corresponding to the first divide ratio value (DRV1); and
clamping the frequency control signal (FCS) within the first code value suppression range while the frequency control signal (FCS) indicates the first divide ratio value (DRV1).

15. The operation method of claim 14, wherein the frequency control signal (FCS) is in a steady state corresponding to the first divide ratio value (DRV1) during a first time period, and
wherein the determining comprises:
monitoring a maximum value (FCS_MAX) and a minimum value (FCS_MIN) of the frequency control signal (FCS) during the first time period;
determining a first threshold value (THCV_U) and a second threshold value (THCV_L) based on the maximum value (FCS_MAX) and the minimum value (FCS_MIN); and
determining the first code value suppression range based on the first threshold value (THCV_U) and the second threshold value (THCV_L).
